(19) Europäisches Patentamt
European Patent Office
Office européen des brevets

(11) EP 2 031 446 A1

(12) **EUROPEAN PATENT APPLICATION**

(43) Date of publication:
**04.03.2009 Bulletin 2009/10**

(51) Int Cl.:
***G03F 7/075*** *(2006.01)* ***G03F 7/20*** *(2006.01)*

(21) Application number: **08162306.8**

(22) Date of filing: **13.08.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **30.08.2007 JP 2007224245**

(71) Applicant: **Fujitsu Limited**
**Kawasaki-shi, Kanagawa 211-8588 (JP)**

(72) Inventors:
- **Nozaki, Koji**
**Kawasaki-shi Kanagawa 211-8588 (JP)**
- **Kozawa, Miwa**
**Kawasaki-shi Kanagawa 211-8588 (JP)**

(74) Representative: **Seeger, Wolfgang et al**
**SEEGER & SEEGER**
**Patentanwälte & European Patent Attorneys**
**Georg-Hager-Strasse 40**
**81369 München (DE)**

(54) **Resist composition for immersion exposure and method for manufacturing a semiconductor device using the same**

(57) According to an aspect of an embodiment, a resist composition for immersion exposure includes a matrix resin so that the matrix resin is turned alkali-soluble by an acid. The resist composition further includes a resin having a side chain containing silicon, the resin being capable of being turned alkali-soluble by an acid, the content of the silicon with respect to the total amount of the matrix resin and the resin being 1% by mass or less.

EP 2 031 446 A1

## Description

BACKGROUND

This art relates to a resist composition used for a resist pattern formed in a semiconductor device manufacturing process using an immersion exposure technique, which is performed by filling the space between the wafer and the projection lens of an exposure apparatus with a medium (liquid) having a refractive index n of higher than 1 (refractive index of air) and can afford higher resolution. This art also relates to a method for manufacturing a semiconductor device using the resist composition.

The packaging density of semiconductor integrated circuits is being increased and, accordingly, the size of minimum patterns are miniaturized to 100 nm or less. In order to form a fine pattern, for example, a resist film is formed over the surface of a work substrate having a thin film and is then subjected to selective exposure, followed by developing a resist pattern. The substrate is dry-etched through the resulting resist pattern as a mask, followed by removing the resist pattern. Thus, a desired pattern is formed.

In order to form a finer pattern, the wavelength of the exposure light source requires to be reduced, and the resist material requires to having a high resolution according to the characteristics of the light source. In order to improve an exposure apparatus so that the exposure light source has a shorter wavelength, unfortunately, enormous cost is required. While ArF (argon fluoride) excimer laser light (wavelength: 193 nm) is being brought into practical use as a next generation exposure light and an alternative to KrF (krypton fluoride) excimer laser light (wavelength: 248 nm) and is beginning to be commercialized, ArF excimer laser light is still expensive. Also, it is not easy to develop a resist material for short-wavelength exposure and is difficult to achieve a finer pattern only by reducing the wavelength of the exposure light source.

Accordingly, immersion exposure receives attention as the latest light exposure technique. Immersion exposure can increase the resolution by filling the space between the projection lens of the exposure apparatus and the wafer with a medium (liquid) having a refractive index n of higher than 1 (refractive index of air). In general, the resolution (R) of an exposure apparatus is expressed by the equation: $R = k \times \lambda/NA$, wherein R represents the resolution, k represents a constant, $\lambda$ represents the wavelength of the light source, and NA represents the numerical aperture of the projection lens. As the light source has a shorter wavelength $\lambda$, and as the projection lens has a higher numerical aperture NA, the exposure apparatus exhibits a higher resolution. In the equation above, NA is represented by the following equation: $NA = n \times \sin\alpha$, wherein n represents a refractive index of the medium through which light passes, and $\alpha$ is an angle formed by the exposure light. Since light exposure is performed in air in the known pattern formatting process, the refractive index n is 1. For immersion exposure, a liquid having a refractive index n of more than 1 fills the space between the projection lens and the wafer. Accordingly, the refractive index n in the above equation for a numerical aperture NA is increased, and the minimum resolution size can be reduced to 1/n at a constant incident angle $\alpha$ of exposure light. Also, the incident angle $\alpha$ can be reduced at a constant numerical aperture NA and, thus, the depth of focus can be advantageously increased to n times.

Although the immersion technique using a liquid having a higher refractive index than air has been known in the field of microscopes, development has just started for applying the immersion technique to microfabrication, and disadvantages of the immersion technique gradually become clear.

One of the disadvantages is that an acid is produced upon exposure in the resist film by the immersion medium and is leached from the resist film to the immersion medium (for example, water) between the projection lens and the wafer, thereby reducing the sensitivity of the resist film. If a resist film permeated with the immersion medium is exposed to an excimer laser light, a chemical reaction that cannot occur in dried atmospheres as in the known technique can occur to degrade the inherent characteristics of the resist. Also, leached components from the resist film may contaminate the optical element and the interior of the exposure apparatus, thereby causing exposure failure to degrade the resolution, and an operational error in the apparatus.

A resist cover film formed on the surface of the resist film is studied to eliminate the above disadvantage. It is however difficult to form the resist cover film by coating without dissolving or mixing with the resist film. In addition, ArF excimer laser light has a short wavelength of 193 nm and cannot pass through ordinary organic materials. The appropriate material of the resist cover film is limited by the structure of the organic materials.

For example, a fluorocarbon resin resist cover film has been known (Japanese Laid-open Patent Publication No. 2006-72326). This resist cover film undesirably leaches out contaminants and mixes with the resist film. It is difficult to obtain a higher contact angle (hydrophobicity) to the immersion medium (for example, water) for higher throughput with smaller amount of defects in the resist film while those problems are taken into account. Since an additional film (resist cover film) is formed after the formation of the resist film, the throughput is decreased and the cost is increased, disadvantageously.

Accordingly, a material that can solve the above problems is desired. For example, the hydrophobicity of the resist film may be increased by changing the structure of the matrix resin. However, it is well known in the art that

excessive hydrophobicity leads to defects in development and makes it difficult to enhance the performance of the resist materials. An acid generator having a structure or characteristic difficult to leach may be added. This technique however often results in loss of the performance of the resist. It is thus considered that those techniques are difficult to apply to practical use.

A method has recently been reported in which a fluorocarbon resin different from the matrix resin is added to a resist composition to increase the hydrophobicity of the resist film (M. Irie et al., Journal of Photopolymer Science and Technology, 19 (4), 565 (2006)). Unfortunately, introduction of a large amount of fluorine atoms into the resist film easily causes phase separation and thus causes striation on the surface of the resist film, and pattern deterioration and defects may occur.

A resist composition containing an alkali-insoluble Si cage compound has been proposed for immersion exposure (Japanese Laid-open Patent Publication No. 2006-309245). However, defects may also occur in the resulting pattern even by use of this resist composition.

Thus, a resist material suitable for immersion exposure and a technique using the resist material have not been yet developed, which prevents the optical element and the interior of the exposure apparatus being contaminated, has a high contact angle for the immersion medium, allows us fine patterning, does not reduce the throughput in semiconductor manufacturing processes, and shows little leaching of the components of the material into the immersion medium Such a material and related techniques are desired.

## SUMMARY

According to an aspect of an embodiment, a resist composition for immersion exposure includes: a matrix resin so that the matrix resin is turned alkali-soluble by an acid, and a resin having a side chain containing silicon, the resin being capable of being turned alkali-soluble by an acid, the content of the silicon with respect to the total amount of the matrix resin and the resin being 1% by mass or less.

## BRIEF DESCRIPTION OF THE DRAWINGS

FIG. 1A is a schematic representation of the mechanism of distribution of a resin having a silicon-containing side chain on the surface of a resist film;

FIG. 1B is a schematic representation of the mechanism of the distribution of the resin having a silicon-containing side chain on the surface of the resin film;

FIG. 2A is a schematic sectional view of the step of forming a resist pattern of an immersion resist composition according to an embodiment, and shows a state in which a resist film has been formed;

FIG. 2B is a schematic representation of an immersion exposure apparatus used in the step of forming a resist pattern according to the embodiment;

FIG. 2C is a fragmentary enlarged view of portion X of the immersion exposure apparatus shown in FIG. 2B;

FIG. 3 is a schematic representation of the step of forming a resist pattern of the immersion exposure resist composition according to the embodiment, and shows a state after immersion exposure;

FIG. 4 is a schematic representation of a method for manufacturing a semiconductor device according to an embodiment, and shows a state in which an insulating interlayer has been formed on a silicon substrate.

FIG. 5 is a schematic representation of the semiconductor device manufacturing method, and shows a state in which a titanium layer has been formed on the insulating interlayer shown in FIG. 4;

FIG. 6 is a schematic representation of the semiconductor device manufacturing method, and shows a state in which a hole pattern has been formed in a resist film formed on the titanium layer;

FIG. 7 is a schematic representation of the semiconductor device manufacturing method, and shows a state in which the hole pattern has been formed in the insulating interlayer;

FIG. 8 is a schematic representation of the semiconductor device manufacturing method, and shows a state in which a Cu layer has been formed over the insulating interlayer having the hole pattern;

FIG. 9 is a schematic representation of the semiconductor device manufacturing method and shows a state where the Cu layer deposited on the insulating interlayer has been removed except for the Cu layer deposited in the hole of the hole pattern;

FIG. 10 is a schematic representation of the semiconductor device manufacturing method and shows a state in which another insulating interlayer has been formed on the Cu plug formed in the hole and a TiN layer;

FIG. 11 is a schematic representation of the semiconductor device manufacturing method and shows a state in which a Cu plug has been formed in the hole of a hole pattern formed on the uppermost insulating interlayer; and

FIG. 12 is a schematic representation of the semiconductor device manufacturing method and shows a state in

which three-layer wires have been formed.

DESCRIPTION OF THE PREFERRED EMBODIMENTS

The present inventors have found through intensive research that a resist pattern having a high sensitivity and high resolution can be formed by using a specific resist composition as a resist material in a process for manufacturing a semiconductor device by immersion exposure. The resist composition contains a resin having a silicon-containing side chain and capable of being turned alkali-soluble in an amount adjusted so that the silicon content in the resist composition is 1% by mass or less. The resin having a silicon-containing side chain is distributed to the surface of the resist film to increase the hydrophobicity. Such a surface prevents the resist component from leaching in the immersion medium between the projection lens and the wafer. Thus, a highly sensitive resist pattern having a high resolution can be produced without deterioration of the resist performance. The process using this resist composition does not require the resist cover film and forms a resist pattern by immersion exposure, thus producing a semiconductor device at the same throughput as in the known lithography.

The present inventors have found through intensive research that a resist pattern having a high sensitivity and high resolution can be formed by using a specific resist composition as a resist material in a process for manufacturing a semiconductor device by immersion exposure. The resist composition contains a resin having a silicon-containing side chain and capable of being turned alkali-soluble so that the silicon content in the resist composition is 1% by mass or less. The resin having a silicon-containing side chain is distributed to the surface of the resist film to increase the hydrophobicity especially on the surface of the resist film. Such a surface prevents the resist components from leaching in the immersion medium between the projection lens and the wafer or a contaminant. Thus, a highly sensitive resist pattern having a high resolution can be produced without deterioration of the resist performance. The process using this resist composition does not require the resist cover film and forms a resist pattern by immersion exposure, thus producing a semiconductor device at the same throughput as in the known lithography.

According to an aspect of the embodiment, a resist composition for immersion exposure is provided which contains a resin having a silicon-containing side chain and capable of being turned alkali-soluble by an acid, and a matrix resin capable of being turned alkali-soluble by acid. The silicon content in the total resin is 1% by mass or less.

In a resist film formed of the immersion resist composition, the resin having a silicon-containing side chain is distributed to the surface of the resist film to increase the hydrophobicity of only the surface of the resist film, and has a high contact angle with the immersion medium. Thus, the resist composition can be prevented from dissolving in the immersion medium to maintain the inherent characteristics of the resist. In addition, the resist pattern can be formed at a high throughput.

Preferably, the resin having a silicon-containing side chain includes an acrylic unit having a silicon-containing side chain and expressed by general formula (1):

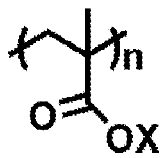

GENERAL FORMULA (1)

where X represents one of the following structural formulas (1) and (2):

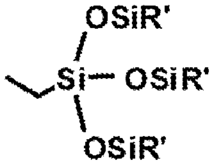

STRUCTURAL FORMULA (1)

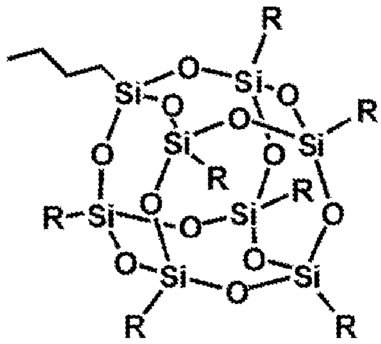

STRUCTURAL FORMULA (2)

where R' may be the same or different and represents an alkyl group having a carbon number of 4 or less, and R may be the same or different and represents any one of the linear, branched, and cyclic alkyl groups having a carbon number of 5 or less.

According to another aspect of the embodiment, a method for manufacturing a semiconductor device is provided which includes the resist pattern forming step of forming a resist film of the resist composition for immersion exposure on a workpiece, subsequently irradiating the resist film with exposure light by an immersion exposure technique, and then performing development, thus forming a resist pattern; and the pattern transferring step of etching the workpiece through the resist pattern as a mask to transfer the pattern to the workpiece.

In this method, the resist pattern forming step forms a resist film of the immersion exposure resist composition on a workpiece on which a pattern such as a wiring pattern is to be formed, and then irradiates the resist film with exposure light by an immersion exposure technique, followed by development. Since the resist film is made of the immersion exposure resist composition, the resist film has a highly hydrophobic surface. Accordingly, the resist film can prevent the resist material from dissolving in the immersion medium between the projection lens and the wafer and a contaminant from leaching into the immersion medium, and allows patterning without degrading the inherent characteristics of the resist. Consequently, a resist pattern can be simply and efficiently formed. Since the method allows highly precise, fine exposure without degrading the performances as the resist film, the resulting resist pattern is fine and highly precise.

In the transferring step, the resist pattern formed in the resist pattern forming step is etched to pattern the workpiece finely and precisely (to transfer the pattern). Thus, a semiconductor device having an extremely fine, highly precise and accurate pattern such as a wiring pattern can be manufactured.

Preferably, the method further includes the transistor forming step of forming a transistor on the surface of a semiconductor substrate and the wiring step of forming wires on the surface onto which the pattern has been transferred.

In this method, the transistor forming step forms a transistor on the surface of a semiconductor substrate. Also, wires are formed in the wiring step, using the pattern (wiring pattern) formed through the resist pattern forming step and the pattern transferring step. Consequently, a high-quality, high-performance semiconductor device can be efficiently manufactured.

Thus, the present embodiment solves problems of the known technique and achieves the following.

The embodiment provides a resist composition for immersion exposure that is not dissolved in the immersion medium, has a high contact angle with the immersion medium, and forms a fine resist pattern without degrading the resist performance.

The embodiment also provides a method capable of mass-producing semiconductor devices. The method prevents the resist material from dissolving in the immersion medium to maintain the resist performance, and prevents a contaminant from leaching and contaminating the optical element and the interior of the exposure apparatus. The method thus can form a fine, highly precise resist pattern by immersion exposure, and provide a high-performance semiconductor device including a fine wiring pattern formed with the fine, precise resist pattern.

Resist Composition for Immersion Exposure

A resist composition for immersion exposure according to an embodiment is intended for a resist pattern used for manufacturing a semiconductor device using an immersion exposure technique.

The immersion exposure resist composition contains a matrix resin so that the matrix resin is turned alkali-soluble by an acid, and a resin having a silicon-containing side chain and capable of being turned alkali-soluble by an

acid (the resin hereinafter simply referred to as silicon side chain-containing resin). Preferably, the composition further contains an acid generator, and optionally appropriately selected other constituents, such as a quencher and a surfactant. Preferably, the immersion exposure resist composition consists essentially of a matrix resin so that the matrix resin is turned alkali-soluble by an acid, and a resin having a side chain containing silicon, the resin being capable of being turned alkali-soluble by an acid, the content of the silicon with respect to the total amount of the matrix resin and the resin being 1% by mass or less. The composition may further contain optionally appropriately selected other constituents as long as the immersion exposure is not inhibited.

Silicon side chain-containing resin capable of being turned alkali-soluble by an acid:

The resin having a silicon-containing side chain and capable of being turned alkali-soluble (hereinafter simply referred to as silicon side chain-containing resin) is added in an amount in which the silicon content in the total resin (the silicon side chain-containing resin and the matrix resin described later) is 1% by mass or less.

The silicon side chain-containing resin is highly hydrophobic. Accordingly, the silicon side chain-containing resin tends to be distributed to the interface with the atmosphere, which is also highly hydrophobic, that is, to the surface of the resist film when it is applied; hence it has a much lower water permeability than a general organic resin. By use of the immersion exposure resist composition containing the silicon side chain-containing resin for a resist film, the silicon side chain-containing resin is distributed to the surface of the resist film. Thus, the silicon side chain-containing resin prevents an acid, an acid generator or an additive from leaching from the resist film to the immersion medium (for example, water), and prevents a side reaction caused by permeating the resist film with the immersion medium.

However, a silicon content of more than 1% by mass leads to an excessively high hydrophobicity, and consequently, development failure is liable to occur. Also, a residue may be produced when a fine pattern is formed.

For example, an immersion exposure resist composition 1 prepared by adding a small amount of silicon side chain-containing resin 1A to a matrix resin 1B and further adding a solvent and an acid generator is applied onto a workpiece (for example, a substrate) 2 and heated (FIG. 1A). Since the atmospheric air is more hydrophobic than the workpiece 2, a coating (resist film) 3 is formed with the highly hydrophobic silicon side chain-containing resin 1A distributed to the interface with the atmospheric air, as shown in FIG. 1B. The resulting resist film has a surface more hydrophobic than the surface of a resist film made of only the matrix resin. Consequently, the resist film prevents the immersion medium (water) from penetrating into the resist film and the components of the resist from leaching. In addition, the resist cover film is not required and, thus, the resist composition of the present embodiment is advantageous in throughput and cost.

Preferably, the silicon side chain-containing resin includes an acrylic unit having a silicon-containing side chain and expressed by general formula (1):

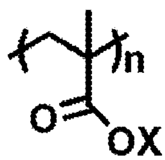

GENERAL FORMULA (1)

where X represents one of the following structural formula (1) and (2):

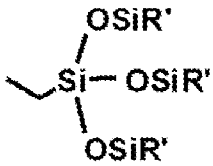

STRUCTURAL FORMULA (1)

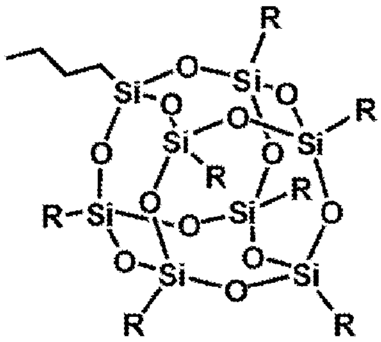

STRUCTURAL FORMULA (2)

where R' in structural formula (1) may be the same or different and represents an alkyl group having a carbon number of 4 or less, and R in structural formula (2) may be the same or different and represents any one of the linear, branched, and cyclic alkyl groups having a carbon number of 5 or less.

The silicon-containing side chain may have any structure without particular limitation as long as the side chain contains a silicon atom. Preferably, a single unit of the side chain contains at least two Si atoms, and more preferably at least three Si atoms. Preferred examples of such a silicon-containing side chain include [bis(trimethylsiloxy)methylsilyl] methyl, pentamethyldisiloxanylpropyl, tris(trimethylsiloxy)silylmethyl, tris(trimethylsiloxy)silylpropyl, and cage siloxane-containing side chains called POSS™ (polyhedral oligomeric silsesquioxane).

The silicon-containing side chain content in the silicon side chain-containing resin is not particularly limited as long as it is turned alkali-soluble by an acid, including the case in which the silicon side chain-containing resin itself is turned alkali-soluble by an acid and the case in which a side chain other than the silicon-containing side chain has an alkali-soluble group, such as carboxyl or hexafluorocarbinol. Preferably, the silicon-containing side chain content is 70 mol% or less, and more preferably 50 mol% or less.

If the silicon-containing side chain content is increased to more than 70 mol%, the alkali solubility may be seriously reduced.

The lower limit of the silicon-containing side chain content can be determined according to the number of Si atoms or the structure. Preferably, the lower limit is 2 mol%. If the silicon-containing side chain content is low, the silicon side chain-containing resin may not be sufficiently distributed to the surface of the resist film even though it is alkali-soluble. Even if it is distributed to the surface, a sufficient hydrophobicity may not be produced.

The silicon side chain-containing resin is turned alkali-soluble by an acid produced by light exposure. Such a silicon side chain-containing resin itself acts as resist and has a small difference in acid reactivity from the matrix resin, accordingly contributing to the increase of the contrast of the resist. In addition, defects in the resist pattern can be prevented.

The resin capable of being turned alkali-soluble by the acid can be selected according to the purpose without particular limitation. Preferably, an acrylic resin is used.

On the other hand, a resin incapable of being turned alkali-soluble by an acid produced by light exposure is likely to cause defects in the resulting pattern in a process requiring a fine and precise resist pattern. Accordingly, a side chain of the silicon side chain-containing resin other than the silicon-containing side chain preferably has acid reactivity or alkali solubility.

The acid-reactive or alkali-soluble side chain can be selected from the side chains generally used as the side chain of the matrix resin of the resist without particular limitation. Examples of such a side chain include t-butyl, tetrahydropyranyl, 2-alkyl-2-adamantyl, 2-alkyl-2-norbornyl, 1-alkylcycloalkyl, 3-oxocyclohexyl, lactone, 2-hydroxyethyl, norbornane lactone, 3-hydroxyadamantyl, carboxyl, and hexafluorocarbinol. Among those preferred are t-butyl, 2-alkyl-2-adamantyl, 2-alkyl-2-norbornyl, 1-alkylcycloalkyl, and 3-oxocyclohexyl, from the viewpoint of easily increasing the hydrophobicity and preventing the deterioration of the contrast of the resist.

Applying acid-reactive groups such as alicyclic or lactone group is preferably to obtain the hydrophilic - hydrophobic balance, and 2-alkyl-2-adamantyl group is preferably used as the acid-reactive alicyclic group.

The weight-average molecular weight of the silicon side chain-containing resin can be arbitrarily set according to the purpose without particular limitation, and is preferably in the range of 1,000 to 1,000,000 in terms of standard polystyrene, and more preferably in the range of 3,000 to 50,000.

A weight-average molecular weight of less than 1,000 may lead to a reduced heat resistance, and a weight-average molecular weight of more than 1,000,000 may lead to difficulty in coating.

The weight-average molecular weight can be measured by gel permeation chromatography (GPC).

The silicon side chain-containing resin content in the resist composition may be set according to the hydrophobicity required for immersion exposure, the silicon-containing side chain content, and other factors without particular limitation, and is preferably 0.1 to 10 parts by mass relative to 100 parts by mass of the matrix resin.

If the silicon side chain-containing resin content is less than 0.1 part by mass relative to 100 parts by mass of the matrix resin, the resulting resist film may not exhibit a desired hydrophobicity. A silicon side chain-containing resin content of more than 10 parts by mass may cause a defect in the resist pattern after etching, depending on the silicon-containing side chain content.

The silicon side chain-containing resin may be synthesized by a known process without particular limitation. For example, a monomer having an alkali-soluble group, which may be replaced with an acid-reactive substituent, is allowed to react with a monomer having a silicon-containing side chain. More specifically, an acid chloride monomer and a silicon compound having a hydroxy group are esterified by the usual manner to obtain a silicon side chain-containing monomer. The silicon side chain-containing monomer is copolymerized with another monomer having an acid-reactive side chain with a radial initiator, such as AIBN. Thus, the silicon side chain-containing resin can be synthesized by processes described in Syntheses 1 to 4 in Examples described later.

The alkali-soluble group can be arbitrarily selected according to the purpose without particular limitation, and may be a carboxylic acid-containing group, a sulfonic acid-containing group, a phenol-containing group, a hexafluorocarbinol-containing group, or a silane or silanol-containing group. Among these preferred are carboxylic acid-containing groups and hexafluorocarbinol-containing groups. These groups can be the same as the alkali-soluble group of the acrylic resin used as the matrix resin, can be uniformly dissolved in an alkali developer without causing peeling-off or residues, and can be removed with the resist film.

The acid-reactive substituent can be selected according to the purpose without particular limitation. Exemplary acid-reactive substituents include groups having an alicyclic group such as adamantane or norbornane, tert-butyl, tert-butoxycarbonyl, tetrahydropyranyl, dimethylbenzyl, 3-oxocyclohexyl, mevalonic lactone, and γ-butyrolactone-3-yl.

Matrix Resin:

The matrix resin can be selected according to the purpose without particular limitation, and preferably from the acrylic resins. Preferably, the matrix resin has an alicyclic structure. Such a matrix resin has a high transmittance for ArF excimer laser light and is highly resistant to etching.

The alicyclic structure is located in at least either the main chain or the side chain of the matrix resin and is in form of cyclohexane, cyclopentane, adamantane, norbornane, decalin, tricyclononane, tricyclodecane, tetracyclododecane, or a derivative of these forms.

Examples of the acrylic resin having an alicyclic structure include acrylic resins having an adamantyl group in a side chain, COMA resins, hybrid resins (alicyclic acrylic-COMA copolymers), and cycloolefin resins. Preferably, resins that can be generally used as a matrix resin of a resist for ArF excimer laser light are used. The matrix resins are turned alkali-soluble by an acid.

Acid Generator:

The acid generator can be selected according to the purpose without particular limitation, and examples of the acid generator include onium salts, such as diphenyliodonium salts and triphenylsulfonium salts; sulfonic acid esters, such as benzyl tosylate and benzyl sulfonate; and halogenated organic compounds, such as dibromobisphenol A and tris(dibromopropyl)isocyanurate. These compounds may be used singly or in combination.

The acid generator content in the resist composition can be set according to the purpose without particular limitation, and is preferably 0.1% to 20% by mass to the mass of the matrix resin.

A resist composition with an acid generator content of less than 0.1% by mass may not exhibit sufficient sensitivity as a chemical amplification resist, and a resist composition with an acid generator content of more than 20% by mass may be inferior in film forming property or resolution.

Other constituents:

The resist composition may contain other constituents according to the purpose without particular limitation, including solvent and known additives. For example, a quencher may be added to increase the exposure contrast, or a surfactant may be added to improve the film forming prpperty.

Generally, the solvent can be used without particular limitation, and exemplary solvents include propyleneglycol methylether acetate, ethyl lactate, 2-heptanone, and cyclohexanone. A cosolvent may further be added, such as propyleneglycol monomethylether or γ-butyrolactone. Preferred organic solvent is having a boiling point of about 100 to

200°C and has sufficient solubility for resins which avoid rapid drying during coating, and ensuring easy coating.

A quencher may be used as needed without particular limitation. Preferably, a nitrogen-containing quencher is used, such as tri-n-octylamine, 2-methylimidazole, 1,8-diazabicyclo[5.4.0]undec-7-en (DBU), or 1,5-diazabicyclo[4.3.0] non-5-ene (DBN).

A surfactant may be used as needed without particular limitation. Preferably, a nonionic surfactant without containing metal ions, such as sodium or potassium, is used. Such surfactants include polyoxyethylene-polyoxypropylene condensation products, polyoxyalkylene alkyl ethers including polyoxyethylene alkyl ethers, polyoxyethylene derivatives, sorbitan fatty acid esters, glycerol fatty acid esters, primary alcohol ethoxylates, phenol ethoxylates, silicones, and fluorine-based surfactants. These surfactants may be use singly or in combination. An ionic surfactant may be used as long as it is not a metal salt, and such a surfactant improves filmforming property.

The contents of those miscellaneous components in the resist composition can be appropriately set according to the type and content of the resin having a silicon-containing side chain, the matrix resin, or the like.

The resist components of the embodiment does not easily leach in the immersion medium. Accordingly, the resist is able to delineate a fine and highly precise resist pattern, maintaining the perfoemance of the resist. Therefore, the resist composition can advantageously be used in manufacture of functional components such as mask patterns, reticle patterns, magnetic heads, LCDs (liquid crystal displays), PDPs (plasma display panels), and SAW filters (surface acoustic wave filters), optical components used for optical fiber connection, minute components such as microactuators, and semiconductor devices. Also, the resist composition can preferably be used in a method for manufacturing a semiconductor device according to an embodiment.

Method for Manufacturing Semiconductor Device

The method for manufacturing semiconductor device includes a resist pattern forming step and a pattern transferring step performing etching through the resist pattern as a mask, and optionally includes a wiring step, a transistor forming step, and other steps as required.

Resist Pattern Forming Step:

In the resist pattern forming step, a resist film is formed of the resist composition of the embodiment on a workpiece. Then, the resist film is irradiated to exposure light using an immersion exposure technique, followed by development. Another treatment may be applied if necessary.

Forming resist film:

The resist film can be formed of the above-described resist composition on a workpiece.

The details of the immersion exposure resist composition are as described above.

The workpiece may be an electronic device, such as a semiconductor device, and specifically a surface of a substrate, such as silicon wafer, or a surface of a low-dielectric film, such as an silicon oxide film.

The low-k-dielectric film can be selected according to the purpose without particular limitation, and is preferably an insulating interlayer having a relative dielectric constant of 2.7 or less. The insulating interlayer is preferably made of porous silica, fluorinated resin, or the like.

The porous silica insulating interlayer can be formed by applying baking of the silica layer enables to dry the solvent and fire the material.

The fluorinated resin insulating interlayer, for example, a fluorocarbon film, can be formed by, for example, deposition using a mixed gas of $C_4F_8$ and $C_2H_2$, or $C_4F_8$ gas as a source by RFCVD (power: 400 W).

The resist film can be formed by a known method, such as, coating.

For coating, any method may be applied according to the purpose without particular limitation. Preferably, for example, spin coating is applied at about 100 to 10,000 rpm, more preferably 800 to 5,000 rpm, for about 1 second to 10 minutes, more preferably 10 to 90 seconds.

The thickness of the resist film can be set according to the purpose without particular limitation, and is preferably, for example, 50 to 500 nm, more preferably 80 to 300 nm.

In a resist film having a thickness of less than 50 nm, a pin hole or defect may occur. A resist film having a thickness of more than 500 nm may lead to low transmission of ArF or $F_2$ excimer laser light and result in low resolution and low exposure sensitivity.

The resist composition applied on a workpiece is preferably baked (heated and dried) during or after coating, under desired conditions by a desired method according to the purpose without particular limitation. For example, the baking temperature is preferably about 40 to 150°C, and more preferably 80 to 120°C. The baking time is preferably about 10 seconds to 5 minutes, and more preferably 30 to 120 seconds.

Thus, the resist film is formed on the workpiece.

Immersion Exposure:

The immersion exposure can performed with a known immersion exposure apparatus. The exposure light is applied to part of the resist film, so that the polarity of the irradiated region is changed. When the immersion exposure resist composition is positive, the irradiated region is removed by the subsequent development. When the resist composition is negative, the unirradiated region is removed. Thus, a resist pattern is completed.

In the immersion exposure apparatus, an immersion medium fills the space between the projection lens and the wafer. The immersion medium can be selected according to the purpose without particular limitation. In order to achieve a high resolution, the medium is preferably a liquid having a higher refractive index than air (refractive index: 1).

The higher the reflective index, the better. Examples of such a liquid having a refractive index of more than 1 include, but not limited to, pure water, oil, glycerol, and alcohol. Among those preferred is pure water (refractive index: 1.44).

The exposure light can be selected according to the purpose without particular limitation, and preferably has a short wavelength. Preferred exposure lights include ArF excimer laser light (193 nm) and $F_2$ excimer laser light (157 nm). These lights can form a highly fine and precise resist pattern.

Development:

When the resist composition is positive, development removes the region irradiated with exposure light. When the immersion exposure resist composition is negative, development removes the unirradiated region.

The irradiated region or the unirradiated region may be removed by an appropriate method according to the purpose without particular limitation. For example, a liquid developer may be used for removal.

The liquid developer can be selected according to the purpose without particular limitation, and is preferably alkaline. For example, 2.38% by mass tetramethyl ammonium hydroxide (TMAH) aqueous solution is preferably used.

Thus, the resist pattern is formed (developed) by dissolving the irradiated region or unirradiated region of the resist film to remove.

An exemplary method for forming the resist pattern will now be described with reference to some figures.

First, the resist composition is applied onto a workpiece (substrate) 4, as shown in FIG. 2A. The coated resist composition is baked (heating and drying) to form a resist film 5. The resist film 5 of the workpiece 4 is irradiated with exposure light with an immersion exposure apparatus 6 shown in FIG. 2B.

FIG. 2B is a schematic representation of an example of the immersion exposure apparatus. The immersion exposure apparatus 6 includes a stepper (step and repeat exposure unit) having a projection lens 7 and a wafer stage 8. The wafer stage 8 is aligned so that the workpiece 4 can be placed on. The space between the projection lens 7 and the workpiece 4 on the wafer stage 8 is filled with an immersion medium 9. The resolution of the stepper is expressed by the following Rayleigh equation (1). As the light source has a shorter wavelength, or as the projection lens 7 has a higher NA value (brightness N. A. (numerical aperture)), the resolution is increased.

$$\text{Resolution} = k \times \lambda/NA \qquad (1)$$

In the equation, k represents a proportional constant, $\lambda$ represents the wavelength of light from the light source, and NA represents the numerical aperture.

FIG. 2C is an enlarged view of the portion X in FIG. 2B. As shown in FIG. 2C, $\theta$ represents an angle formed by exposure light. The immersion medium 9 through which the exposure light passes has a refractive index n. Since general light exposure process uses air as the medium through which the exposure light passes, the refractive index n is 1, and the numerical aperture NA of the projection lens (reducing projection lens) 7 is theoretically at most 1.0, and practically as low as about 0.9 ($\theta$ = 65°). On the other hand, the immersion exposure apparatus 6 uses a liquid having a refractive index n higher than 1 as the immersion medium 9, thus increasing n. Consequently, the minimum resolution size can be reduced to 1/n at a constant incident angle $\theta$ of the exposure light; $\theta$ can be reduced at a constant numerical aperture NA; and the focal depth can be increased to n times. For example, when pure water is used as the immersion medium 9 with an ArF excimer laser as the light source, the refractive index n is 1.44, and the NA value can be increased to about 1.35 theoretically. Thus, finer pattern can be formed.

The workpiece (substrate) 4 is placed on the wafer stage 8 of the immersion exposure apparatus 6, and the resist film 5 is subjected to exposure by being irradiated with the exposure light (for example, ArF excimer laser light) in a pattern manner, followed by development. The region of the resist film 5 irradiated with the ArF excimer laser light

is dissolved and removed to form a resist pattern 5A on the workpiece (substrate) 4 (resist pattern is developed), as shown in FIG. 3.

Although the above-described process forms a resist pattern of a positive immersion exposure resist composition for ArF excimer laser light, various combinations of the exposure light and the immersion exposure resist composition can be selected according to the purpose without particular limitation.

Pattern Transferring Step

In the pattern transferring step, the workpiece is etched through the resist pattern as a mask (using as a mask pattern) to transfer the pattern to the workpiece.

The etching is performed by an appropriate known method according to the purpose without particular limitation. For example, dry etching may preferably be applied. The etching conditions are appropriately selected according to the purpose without particular limitation.

Thus, the pattern is transferred to the workpiece by etching through the resist pattern as a mask.

Wiring Step

In the wiring step, wires are formed on the workpiece having the transferred pattern.

The wires are formed by applying a wire precursor, or a conducting material, to the spaces formed in the pattern (wiring pattern) in the pattern transferring step.

The conducting material can be applied by a known plating method, such as electroless plating or electroplating.

Thus, wires are formed on the workpiece.

The method for manufacturing a semiconductor device according to the embodiment prevents the resist components from leaching in the immersion medium to maintain its performance as a resist and prevents the optical element and the interior of the exposure apparatus from being contaminated. Thus, the method ensures highly precise exposure and can simply and efficiently form a fine and highly precise resist pattern by immersion exposure. By use of the resulting resist patterns, high-performance semiconductor devices having fine wiring patterns can simply and efficiently be mass-produced. Such semiconductor devices may be flash memories, DRAM's, FRAM's, and other various types of semiconductor devices.

Examples

The present embodiment will further be specifically described with reference to Examples and Comparative Examples. However, the Examples below do not limit the invention.

Synthesis 1: Synthesizing silicon side chain-containing resin 1

A 100 ml round-bottom flask is charged with 1.98 g of mevalonic lactone methacrylate, 2.43 g of 2-methyl-2-adamantyl methacrylate, and 1.97 g of methacryloxymethyl-tris-(trimethylsiloxy)silane (produced by Gelest), and 8.3 ml of MIBK was added. Oxygen was sufficiently removed from the reaction system by stirring with a Teflon (registered trademark)-coated stirrer bar and bubbling nitrogen gas for 15 minutes. Then, 0.62 g of AIBN (2,2'-azobisisobutyronitrile) was added as a radical polymerization initiator. Thus, the reaction mixture was subjected to a reaction in a three-neck flask equipped with a Liebig condenser in a 70°C oil bath for 6 hours.

The resulting solution of the reaction product was cooled to room temperature. Then, the solution was poured into 1,000 ml of methanol with stirring and a white precipitate was produced. The precipitation was filtered through a glass filter and dried for 6 hours in a 50°C vacuum drying oven to give the white powder. The powder was dissolved in about 50 ml of THF and precipitated again with 1,000 ml of methanol. After filtration and vacuum drying, the product was subjected to the above purification again to yield 2.5 g of resin expressed by structural formulas (3). The weight-average molecular weight (in terms of standard polystyrene) of the resin was measured by GPC and was 13,600. The composition ratio determined by 1H-NMR was as shown in structural formula (3).

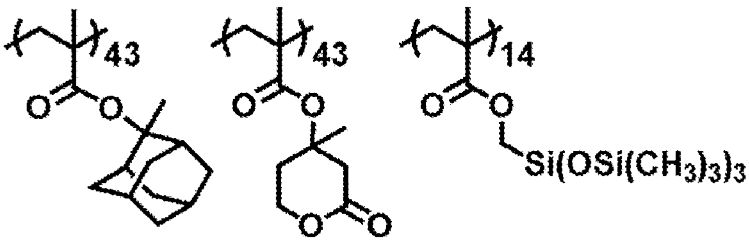

STRUCTURAL FORMULA (3)

Synthesis 2: Synthesizing silicon side chain-containing resin 2

A 100 ml round-bottom flask was charged with 1.53 g of 3-γ-butyrolactone methacrylate, 2.46 g of 2-ethyl-2-adamantyl methacrylate, and 2.1 g of methacryloxypropyl-tris-(trimethylsiloxy)silane (produced by Gelest), and 8.3 ml of MIBK was added. Oxygen was sufficiently removed from the reaction system by stirring with a Teflon (registered trademark)-coated stirrer bar and bubbling nitrogen gas for 15 minutes. Then, 0.74 g of AIBN was added as a radical polymerization initiator. Thus, the reaction mixture was subjected to a reaction in a three-neck flask equipped with a Liebig condenser in a 70°C oil bath for 6 hours.

The resulting solution of reaction product was cooled to room temperature. Then, the solution was poured into 1,000 ml of methanol with stirring and a white precipitate was produced. The precipitation was filtered through a glass filter and dried for 6 hours in a 50°C vacuum drying oven to give the white powder. The powder was dissolved in about 50 ml of THF and precipitated again with 1,000 ml of methanol. After filtration and vacuum drying, the product was subjected to the above purification again to yield 2.99 g of resin expressed by structural formulas (4). The weight-average molecular weight (in terms of standard polystyrene) of the resin was measured by GPC and was 19,600. The composition ratio determined by 1H-NMR was as shown in structural formulas (4).

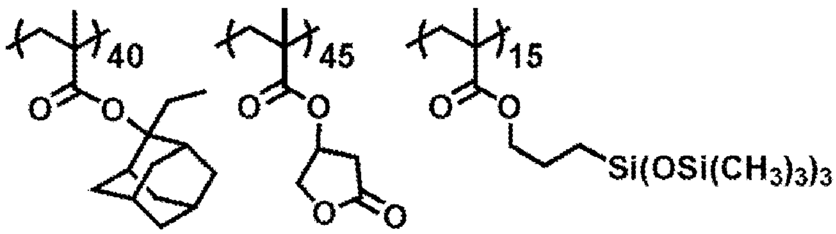

STRUCTURAL FORMULA (4)

Synthesis 3: Synthesizing silicon side chain-containing resin 3

A 100 ml round-bottom flask was charged with 2.17 g of mevalonic lactone methacrylate, 2.66 g of 2-methyl-2-adamantyl methacrylate, and 2.5 g of heptacyclopentyl-T8-silsesquioxane propyl methacrylate (produced by Gelest), and 8.1 ml of THF was added. Oxygen was sufficiently removed from the reaction system by stirring with a Teflon (registered trademark)-coated stirrer bar and bubbling nitrogen gas for 15 minutes. Then, 0.6 g of AIBN was added as a radical polymerization initiator. Thus, the reaction mixture was subjected to a reaction in a three-neck flask equipped with a Liebig condenser in a 60°C oil bath for 5 hours.

The resulting solution of reaction product was cooled to room temperature and diluted to about 100 ml with THF. Then, the solution was poured into 1,000 ml of methanol with stirring and a white precipitate was produced. The precipitation was filtered through a glass filter and dried for 6 hours in a 50°C vacuum drying oven to give the white powder. The powder was dissolved in about 100 ml of THF and precipitated again with 1,000 ml of methanol. After filtration and vacuum drying, the product was subjected to the above purification again to yield 4.65 g of resin expressed by structural formulas (5). The weight-average molecular weight (in terms of standard polystyrene) of the resin was measured by GPC and was 16,700. The composition ratio determined by 1H-NMR was as shown in structural formulas (5).

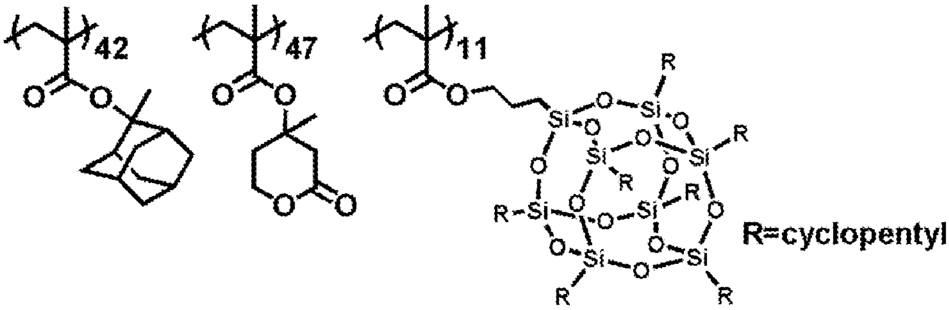

STRUCTURAL FORMULA (5)

Synthesis 4: Synthesizing silicon side chain-containing resin 4

A 100 ml round-bottom flask was charged with 6.0 g of 2-methyl-2-adamantyl methacrylate and 2.4 g of heptaisobutyl-T8-silsesquioxane propyl methacrylate (produced by Gelest), and 9.5 ml of THF was added. Oxygen was sufficiently removed from the reaction system by stirring with a Teflon (registered trademark)-coated stirrer bar and bubbling nitrogen gas for 15 minutes. Then, 0.69 g of AIBN was added as a radical polymerization initiator. Thus, the reaction mixture was subjected to a reaction in a three-neck flask equipped with a Liebig condenser in a 60°C oil bath for 5 hours.

The resulting solution of reaction product was cooled to room temperature and diluted to about 100 ml with THF. Then, the solution was poured into 1,000 ml of methanol with stirring and a white precipitate was produced. The precipitation was filtered through a glass filter and dried for 6 hours in a 50°C vacuum drying oven to give the white powder. The powder was dissolved in about 100 ml of THF and precipitated again with 1,000 ml of methanol. After filtration and vacuum drying, the product was subjected to the above purification again to yield 4.5 g of resin expressed by structural formulas (6). The weight-average molecular weight (in terms of standard polystyrene) of the resin was measured by GPC and was 12,300. The composition ratio determined by 1H-NMR was as shown in structural formulas (6).

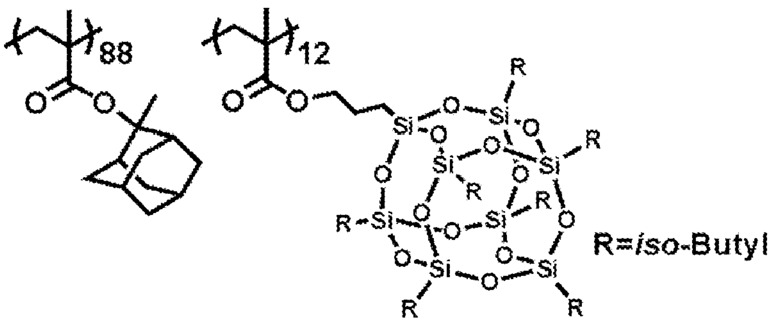

STRUCTURAL FORMULA (6)

Example 1

Preparing immersion exposure resist composition

Matrix resins (acrylic resins) (a) to (c) expressed by structural formulas (7) to (9) and silicon side chain-containing resins 1 to 4 expressed by structural formulas 3 to 6 synthesized in Syntheses 1 to 4 were used according to the compositions shown in Table 1. Then, 3 parts by mass of triphenylsulfonium nonafluorobutane sulfonate (produced by Midori Kagaku) as the acid generator and 900 parts by mass of propylene glycol methyl ether acetate (PGMEA) as the solvent were added relative to 100 parts by mass of the matrix resin, and thus immersion exposure resist compositions A to R were prepared.

Matrix resin (a) (weight-average molecular weight (Mw) =15, 600)

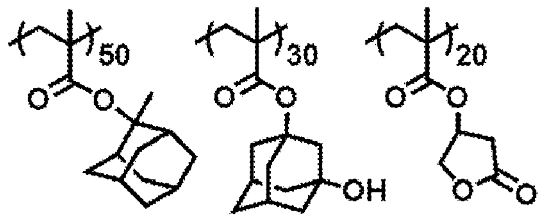

STRUCTURAL FORMULA (7)

Matrix resin (b) (weight-average molecular weight (Mw)=9,600)

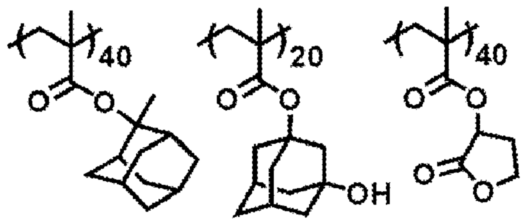

STRUCTURAL FORMULA (8)

Matrix resin (C) (weight-average molecular weight (Mw) = 7,100)

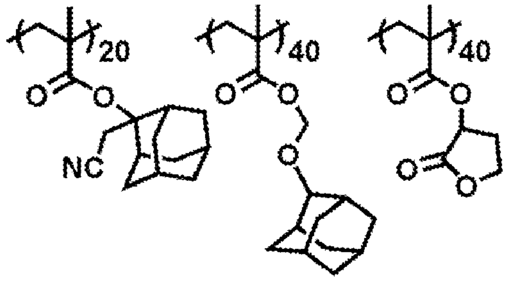

STRUCTURAL FORMULA (9)

Table 1

| IMMERSION EXPOSURE RESIST COMPOSITION | MATRIX RESIN | SILICON SIDE CHAIN-CONTAINING RESINS | | Si CONTENTS /wt% |
|---|---|---|---|---|
| | | SYNTHESIS No. | ADDITIVE AMOUNT (RELATIVE TO 100 PARTS BY MASS OF THE MATRIX RESIN) | |
| A | a | 1 | 0.1 | 0.0085 |
| D | a | 1 | 0.5 | 0.033 |
| C | a | 1 | 1 | 0.065 |
| D | a | 1 | 5 | 0.33 |
| E | a | 1 | 10 | 0.65 |
| F | b | 1 | 1 | 0.065 |
| G | c | 1 | 1 | 0.065 |
| H | b | 2 | 3 | 0.2 |
| I | c | 4 | 2 | 0.17 |
| J | c | 2 | 3 | 0.2 |
| K | a | - | - | - |
| L | b | - | - | - |
| M | c | - | - | - |
| N | a | 3 | 0.2 | 0.016 |
| O | a | 3 | 0.5 | 0.041 |
| P | a | 3 | 1 | 0.081 |
| Q | a | 3 | 5 | 0.41 |
| R | a | 3 | 10 | 0.81 |

"A" to "R" shown in Table 1 correspond to immersion exposure resist compositions A to R, respectively. Immersion exposure resist compositions K to M of the resist compositions A to R correspond to comparative examples, and immersion exposure resist compositions A to J and N to R correspond to Examples of the embodiment.

Example 2

Evaluating hydrophobicity

Each of the immersion exposure resist compositions A to R shown in Tale 1 was applied onto a substrate coated with an antireflection coating (ARC-39 manufactured by Nissan Chemical Industries) by spin coating at 1,500 rpm for 20 seconds. The substrate was baked at 110°C for 60 seconds on a hot plate. Thus, a 250-nm thick resist film was formed. The static contact angle and the receding contact angle (dynamic contact angle) of pure water with each resist film were measured and compared.

The static contact angle was measured with a contact angle meter (CA-W 150, manufactured by Kyowa Interface Science) at an ejection time of 40 ms.

For the receding contact angle, the substrate having the resist film was fixed on an inclining stage whose angle was able to be continuously changed with a self-made apparatus, and a droplet (50 μl) of pure water was dropped onto the surface of the resist film. On dropping the droplet, the stage was slanted at a constant speed. Thus, receding contact angle was determined by measuring a shape formed by moving the droplet for a predetermined time. The results are shown in Table 2.

Table 2

| IMMERSION EXPOSURE RESIST COMPOSITION | STATIC CONTACT ANGLE /° | RECEDING CONTACT ANGLE /° |
|---|---|---|
| A | 70.9 | 55.2 |
| B | 73.6 | 55.7 |
| C | 78.4 | 61.8 |
| D | 88.5 | 79.0 |
| E | 91.2 | 81.5 |
| F | 75.6 | 60.0 |
| G | 78.5 | 63.7 |
| H | 89.3 | 80.7 |
| I | 93.5 | 83.2 |
| J | 90.1 | 80.1 |
| K | 69.1 | 53.7 |
| L | 67.8 | 52.2 |
| M | 69.8 | 55.0 |
| N | 71.6 | 59.9 |
| O | 71.4 | 62.7 |
| P | 71.6 | 63.2 |
| Q | 72.5 | 66.7 |
| R | 73.0 | 66.3 |

Table 2 shows that the immersion exposure resist compositions A to J and N to R of Examples, each of which contained a silicon side chain-containing resin, exhibited higher contact angles and hence higher hydrophobicity than immersion exposure resist compositions K to M, which did not contain a silicon side chain-containing resin.

In particular, immersion exposure resist compositions D, E, H, I, and J exhibited receding contact angles of 70° or more. It is considered that a resist film having such a receding contact angle is effective in reducing the occurrence of defect in the resist pattern formed by immersion exposure with increasing the throughput. It has been found that these resist compositions have the effect of increasing the hydrophobicity even though their Si contents are as low as 0.17% to 0.65% by mass.

Example 3

Evaluation of resist performance

Each of the immersion exposure resist compositions K to M, D, H, I, and J shown in Table 1 was applied onto a substrate coated with an antireflection coating (ARC-39 manufactured by Nissan Chemical Industries) by spin coating at 1,500 rpm for 20 seconds. The substrate was baked at 110°C for 60 seconds on a hot plate. Thus, a 250 nm thick resist film was formed.

Subsequently, the space between the resist film and the optical element of the immersion exposure apparatus was filled with water, and the resist film was exposed to ArF excimer laser light (wavelength: 193 nm).

The resulting resist film was subjected to development with a 2.38% by mass TMAH aqueous solution to remove the irradiated region of the resist film. Thus, 200 nm line/space patterns were developed exposures shown in Table 3, respectively.

Table 3

| IMMERSION EXPOSURE RESIST COMPOSITION | RESPECTIVE EXPOSURE /mJ/cm$^2$ |
|---|---|
| K | 23 |

(continued)

| IMMERSION EXPOSURE RESIST COMPOSITION | RESPECTIVE EXPOSURE /mJ/cm2 |
|---|---|
| L | 26 |
| M | 22 |
| D | 23 |
| H | 26 |
| I | 22 |
| J | 22 |

Table 3 shows that immersion exposure resist compositions D, H, I, and J were each formed into a line/space pattern at the same sensitivity as the immersion exposure resist compositions K to M not containing a silicon side chain-containing resin even though the resist compositions of the Examples contained a silicon side chain-containing resin. The sensitivity was not varied depending on whether the silicon side chain-containing resin had been added. It has been found that the performance of the resist is not degraded. Furthermore, the immersion exposure compositions of the Examples and Comparative Examples did not show residues.

Example 4

Leaching evaluation of contaminant

Each of the immersion exposure resin compositions K to M, A, D, E, H, I, and J shown in Table 1 was applied onto a 6-inch wafer coated with an anti-reflection coating (ARC-39 manufactured by Nissan Chemical Industries) by spin coating at 1,500 rpm for 20 seconds. The wafer was baked at 110°C for 60 seconds on a hot plate. Thus, a 250 nm thick resist film was formed. The resulting resist film was irradiated with 254 nm DUV lamp at an exposure of 50 mJ/cm$^2$ while the surface of the wafer (area: 154 cm$^2$) was rinsed in 5 ml of pure water. Thus, a sample solution was prepared.

Then, 5 μl of the resulting sample solution was analyzed with LC-MS (Model 1100 manufactured by Agilent Technologies) to determine the amount of anion ($C_4F_9SO_3^-$) of the acid generator leached from the resist film. The results are shown in Table 4.

Table 4

| IMMERSION EXPOSURE RESIST COMPOSITION | LEACHING AMOUNT /ppb |
|---|---|
| K | 60.5 |
| L | 72.3 |
| M | 95.8 |
| A | 32.9 |
| D | 38.6 |
| E | 22.4 |
| H | 45.2 |
| I | 63.7 |
| J | 52.1 |

Table 4 shows that the amounts of contaminant leached from the resist films formed of immersion exposure resist compositions A, D, and E containing a silicon side chain-containing resin were significantly lower than the amount of contaminant from immersion exposure resist composition K (matrix resin a) not containing a silicon side chain-containing resin. Also, the amount of contaminant leached from the resist film formed of immersion exposure resist composition H was significantly lower than that of immersion exposure resist composition L (matrix resin b). The amounts of contaminant leached from the immersion resist compositions I and J were also significantly lower than the amount of contaminant from immersion exposure resist composition M (matrix resin c). These results clearly show that contaminants leached into the immersion medium, which are problems in immersion exposure, can be reduced by use of the immersion

exposure resist compositions of the Examples of the embodiment, each containing a silicon side chain-containing resin.

Example 5

Manufacturing Semiconductor Device

As shown in FIG. 4, an insulating interlayer 12 was formed on a silicon substrate 11, and then a titanium film 13 was formed on the insulating interlayer 12 by sputtering, as shown in FIG. 5. Turning to FIG. 6, a resist pattern 14 was formed by ArF immersion exposure. The titanium film 13 was patterned to form a hole 15a by reactive ion etching through the resist pattern 14 as a mask. Subsequently, the resist pattern 14 was removed by reactive ion etching, and a hole 15b was formed in the insulating interlayer 12 by the reactive ion etching through the titanium film 13 as a mask, as shown in FIG. 7.

Then, the titanium film 13 was wet-etched to remove. A TiN barrier metal film 16 was formed on the insulating interlayer 12 by sputtering, as shown in FIG. 8. Subsequently, a Cu layer 17 was formed on the TiN layer 16 by electroplating. Then, the substrate was planarized by CMP with the barrier metal and the Cu layer (first metal film) remaining in the trench corresponding to the hole 15b shown in FIG. 7. Thus, a wire 17a of a first layer was formed, as shown in FIG. 9.

Turning to FIG. 10, an insulating interlayer 18 was formed over the wire 17a of the first layer. Subsequently, a Cu plug (second metal film) 19 for connecting the wire 17a of the first layer to an upper wire formed later and a TiN layer 16a were formed in the same manner as in the steps shown in FIGs. 4 to 9, as shown in FIG. 11.

The steps above were repeated, and thus a semiconductor device was completed which has a multilayer structure including the wire 17a of the first, the wire 20 of the second layer, and a wire 21 of a third layer on the silicon substrate 11, as shown in FIG. 12. The TiN barrier metal layers formed under the wires of the respective layers are omitted in FIG. 12.

In Example 5, the resist pattern 14 was formed of immersion exposure resist composition C prepared in Example 1, by immersion exposure.

The insulating interlayer 12 was a lowk-dielectric constant film having a dielectric constant of 2.7 or less. Such an insulating interlayer 12 may be a porous silica film (Ceramate NCS produced by Catalysts & Chemicals Industries, dielectric constant: 2.25) or a fluorocarbon film (dielectric constant: 2.4) deposited by RFVCD (power: 400 W) using a mixed gas of $C_4F_8$ and $C_2H_2$ or $C_4F_8$ gas as a source gas.

As described above, the resist film formed of immersion exposure resist composition of the embodiment has a high hydrophobicity and prevents contaminants, which may cause a problem in immersion exposure, from leaching from the acid generator in the resist film to the immersion medium, and from contaminating the optical element and the interior of the exposure apparatus. The resist film can be formed into a fine resist pattern by fast scanning exposure.

Use of the immersion exposure resist composition of the embodiment allows a fine and highly precise resist pattern to be formed simply and efficiently. Accordingly, the immersion exposure resist composition is advantageous in forming fine wires and multilayer wires according to the demand for highly integrated and high-performance semiconductor devices. Thus, use of the immersion exposure resist composition leads to greatly increased mass-productivity of semiconductor devices.

The immersion exposure resist composition of the embodiment prevents the resist film from dissolving in the immersion medium to maintain the resist performance, and the resist film formed of the resist composition has a high contact angle with the immersion medium. Therefore, the immersion exposure resist composition is suitable to form resist patterns and can be advantageously used in manufacture of functional components such as mask patterns, reticle patterns, magnetic heads, LCDs (liquid crystal displays), PDPs (plasma display panels), and SAW filters (surface acoustic wave filters), optical components used for optical fiber connection, fine components such as microactuators, and semiconductor devices. Also, the immersion exposure resist composition can be preferably used in the method for manufacturing a semiconductor device of the embodiment.

The semiconductor device manufacturing method of the embodiment can advantageously be applied to the manufacture of various semiconductor devices, such as flash memory, DRAM, and FRAM.

What is claimed is:

## Claims

**1.** A resist composition for immersion exposure comprising:

a matrix resin so that the matrix resin is turned alkali-soluble by an acid, and
a resin having a side chain containing silicon, the resin being capable of being turned alkali-soluble by an acid, the content of the silicon with respect to the total amount of the matrix resin and the resin being 1% by mass or less.

2. The resist composition according to claim 1, wherein the resin includes:

an acrylic unit having a side chain containing silicon and expressed by general formula (1):

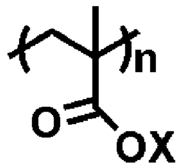

GENERAL FORMULA (1)

wherein X represents one of the following structural formulas (1) and (2):

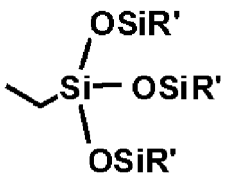

STRUCTURAL FORMULA (1)

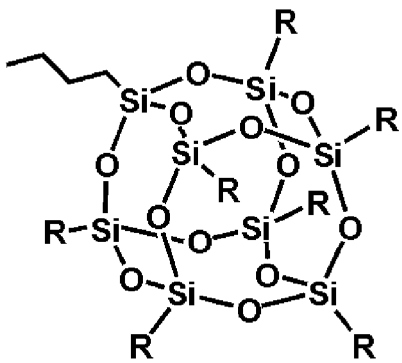

STRUCTURAL FORMULA (2)

wherein each R' represents an alkyl group having a carbon number of 4 or less and R's are the same or different, and each R and represents any one of the linear, branched, and cyclic alkyl groups having a carbon number of 5 or less and Rs are the same or different.

3. The resist composition according to claim 1, wherein the resin is an acrylic resin.

4. The resist composition according to claim 2, wherein the acrylic unit expressed by general formula (1) includes:

an alicyclic group having reactivity to an acid; and
a lactone group having reactivity to an acid.

5. The resist composition according to claim 4, wherein the alicyclic group having reactivity to an acid is 2-alkyl-2-adamantyl group.

6. The resist composition according to claim 1, wherein the resin is synthesized by reacting a monomer having an alkali-soluble group with a monomer having a side chain containing silicon.

7. The resist composition according to claim 1, wherein the matrix resin is an acrylic resin.

8. The resist composition according to claim 7, wherein the acrylic resin has an alicyclic group having reactivity to an acid.

9. The resist composition according to claim 1, wherein the content of the resin is 0.1 to 10 parts by mass relative to 100 parts by mass of the matrix resin.

10. The resist composition according to claim 1, further comprising an acid generator.

11. A method for manufacturing a semiconductor device comprising:

forming a resist film of a resist composition for immersion exposure on a workpiece, the resist composition including:

a matrix resin so that the matrix resin is turned alkali-soluble by an acid, and
a resin having a side chain containing silicon, the resin being capable of being turned alkali-soluble by an acid, the content of the silicon with respect to the total amount of the matrix resin and the resin being 1% by mass or less;
irradiating the resist film with exposure light by an immersion exposure technique;
developing the resist film to form a resist pattern; and etching the workpiece through the resist pattern as a mask to transfer the pattern to the workpiece.

**12.** The method according to claim 11, further comprising:

forming a transistor on the surface of a semiconductor substrate; and
forming wires on the surface onto which the pattern has been transferred.

**13.** The method according to claim 11, wherein the resist is immersed in water or aqueous solution while the resist film is irradiated with exposure light by the immersion exposure technique.

**14.** The method according to claim 11, wherein the workpiece is a surface of an insulating interlayer having a relative dielectric constant of 2.7 or less.

**15.** The method according to claim 14, wherein the insulating interlayer is porous silica or fluorinated resin.

FIG. 1A

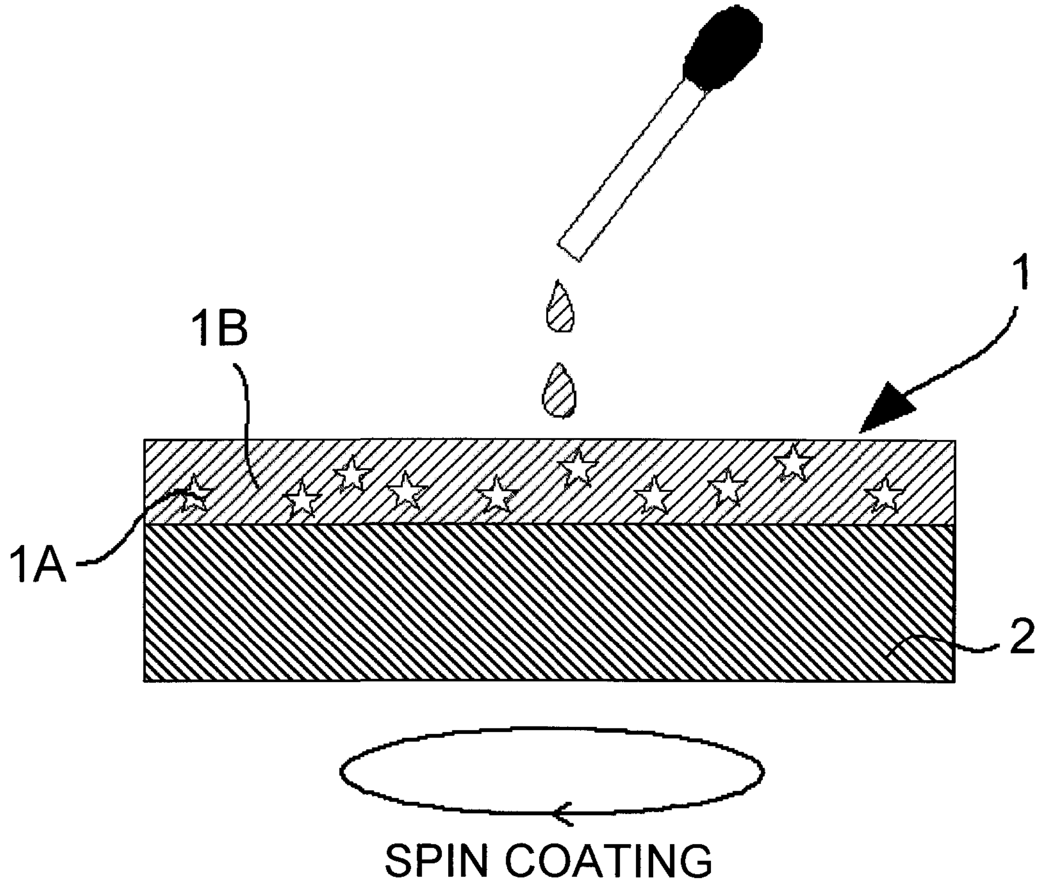


FIG. 1B

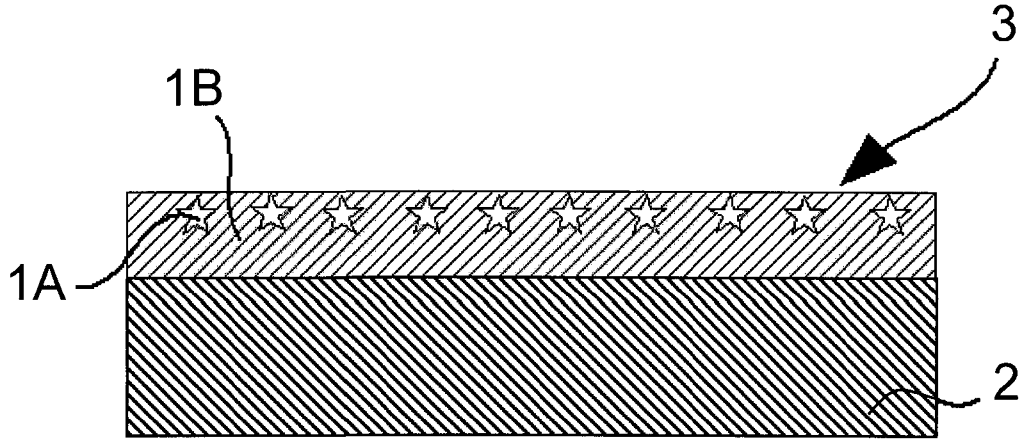

FIG. 2A

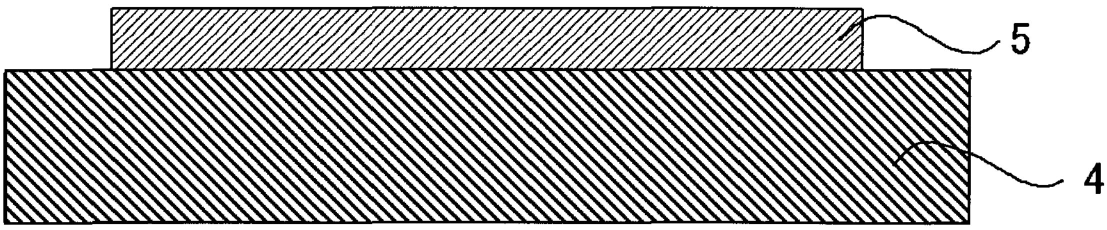


FIG. 2B

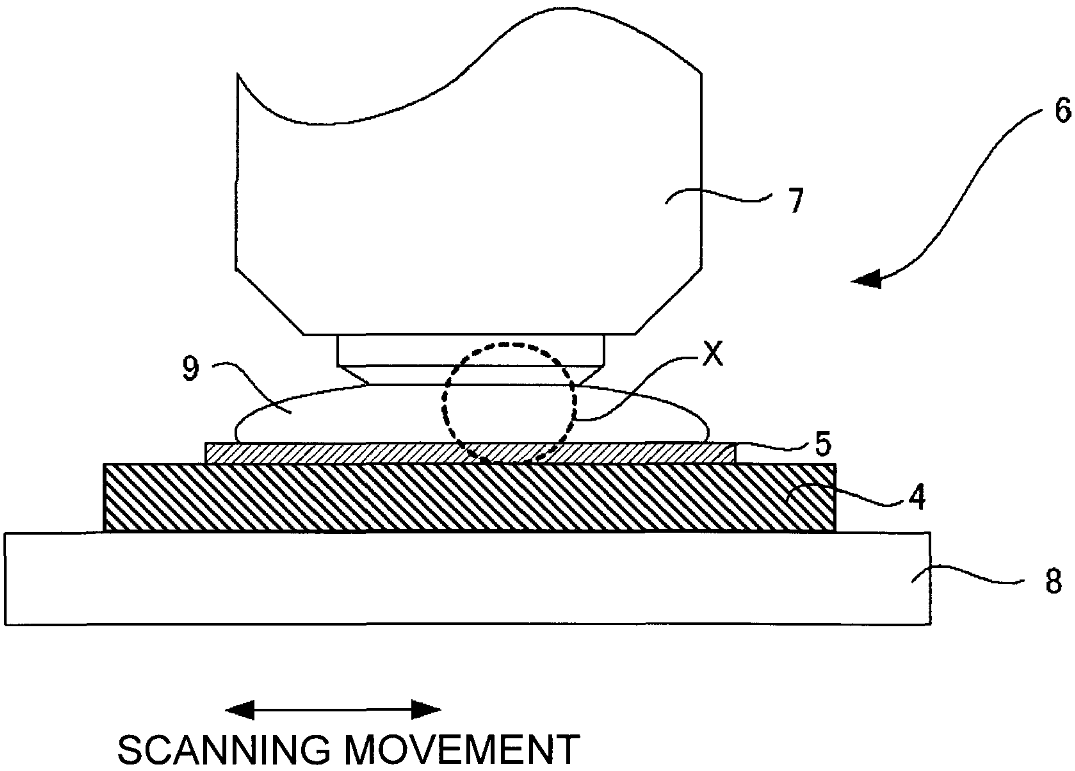

FIG. 2C

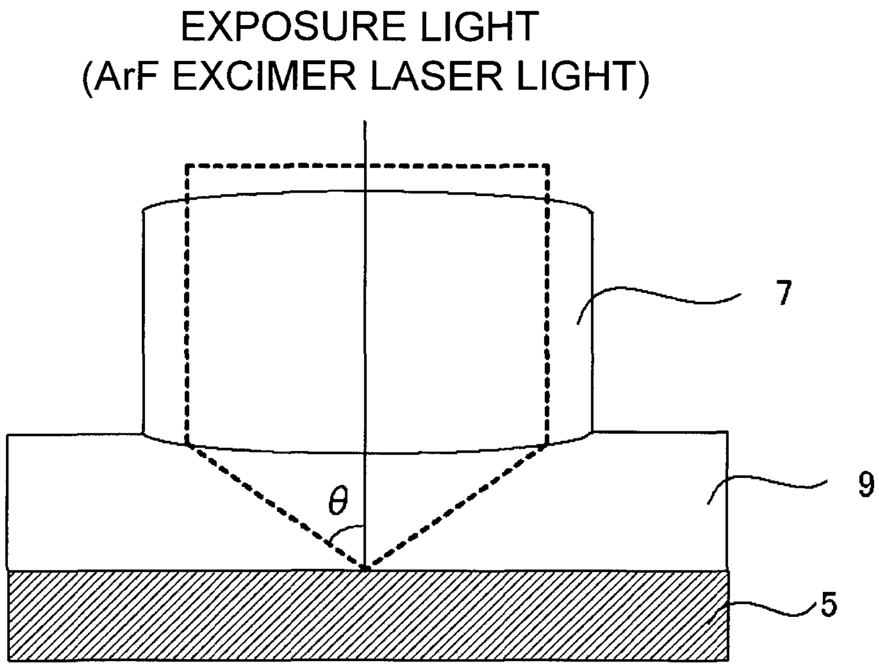


FIG. 3

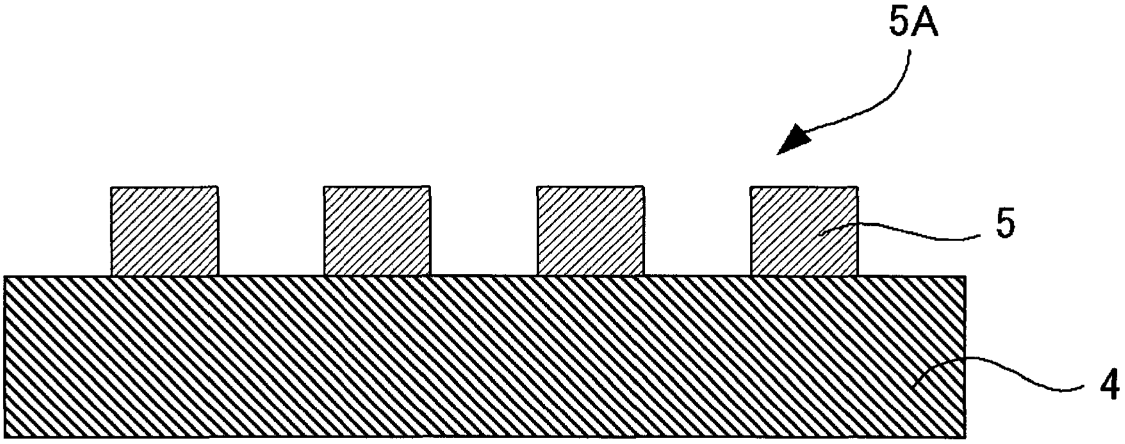

FIG. 4

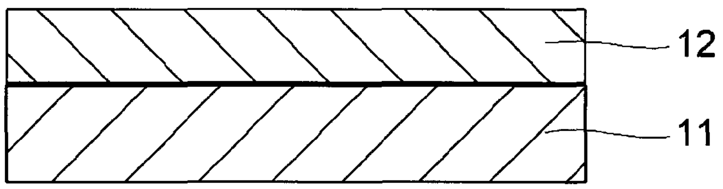


FIG. 5

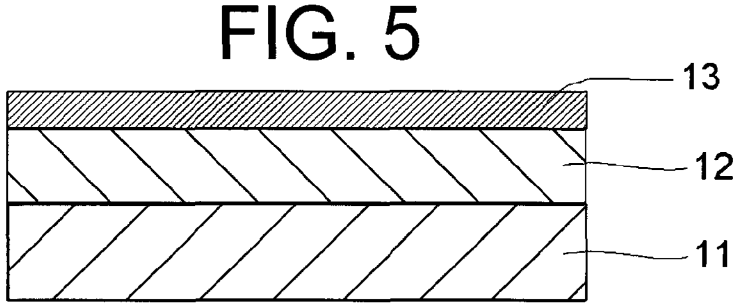


FIG. 6

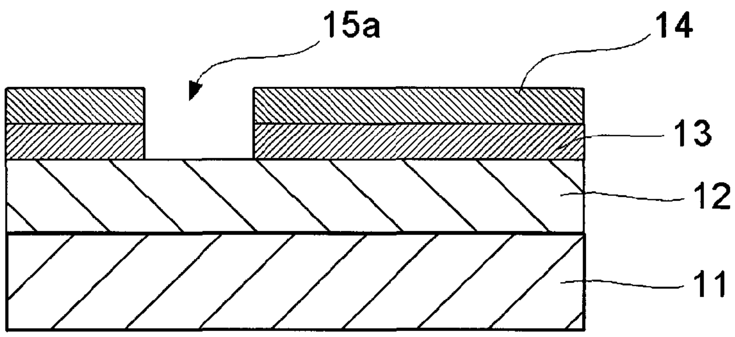


FIG. 7

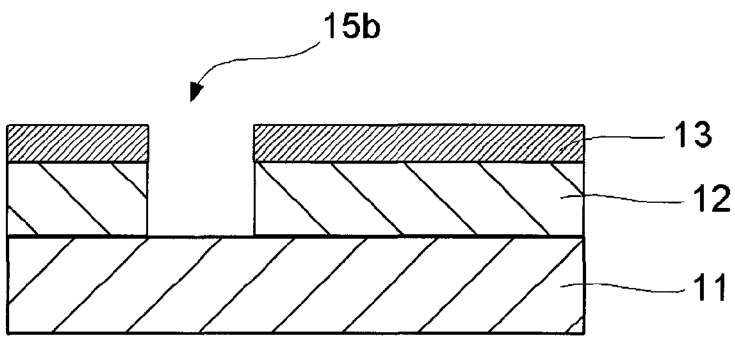

FIG. 8

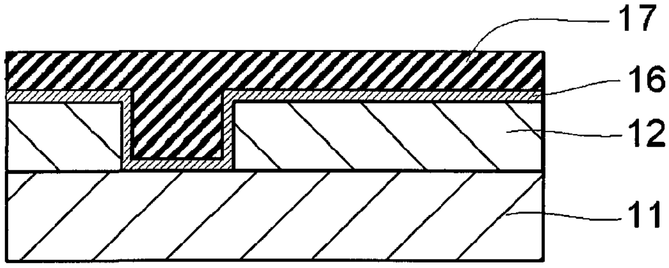


FIG. 9

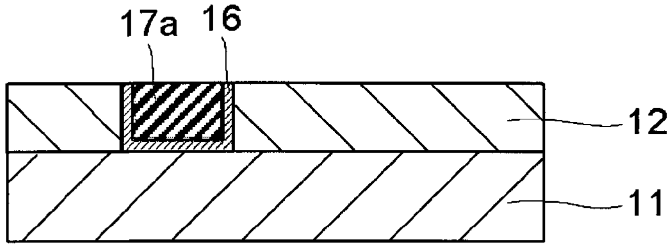


FIG. 10

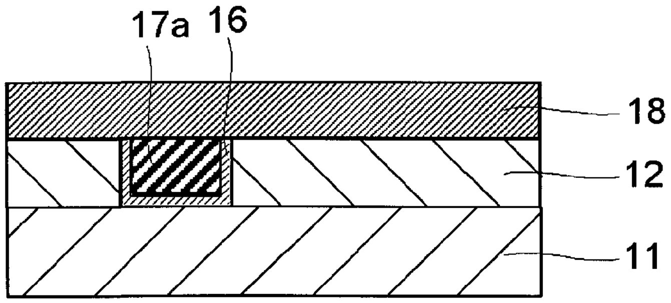


FIG. 11

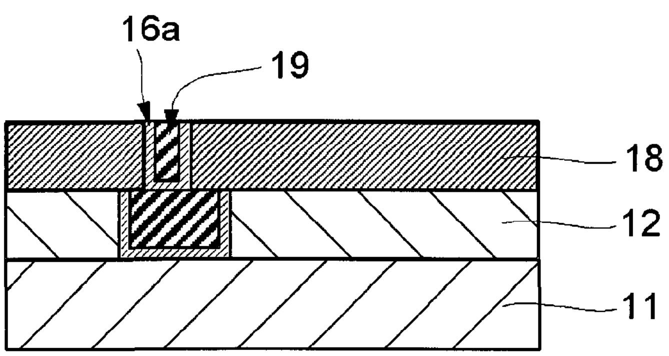

FIG. 12

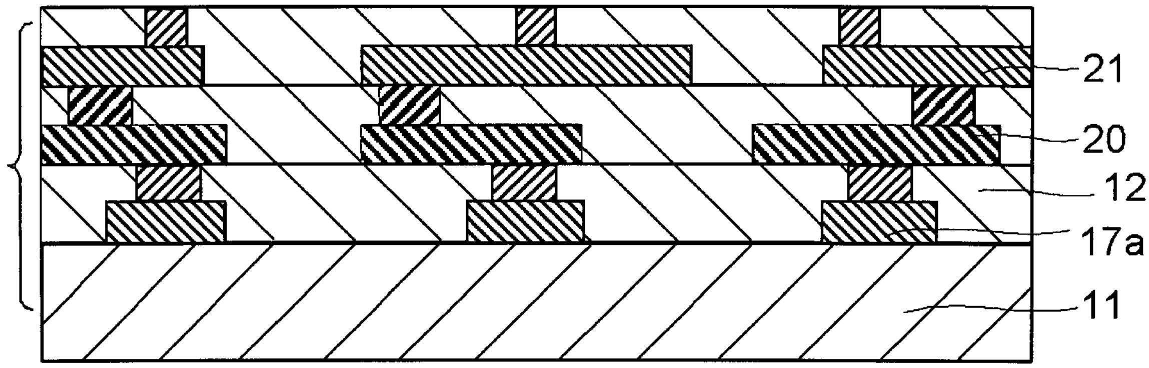

Europäisches Patentamt
European Patent Office
Office européen des brevets

# EUROPEAN SEARCH REPORT

Application Number
EP 08 16 2306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 764 652 A (FUJIFILM CORP [JP]) 21 March 2007 (2007-03-21) * paragraphs [0045] - [0057], [0061] - [0080], [0114]; compounds 1-33 * * paragraphs [0196] - [0201], [0216] - [0246], [0258] - [0271]; claims 5,6,10 * * paragraphs [0124] - [0154], [0181], [0182]; compound Z2 * * paragraphs [0319], [0320], [0324], [0332], [0334] - [0339], [0101], [0084] * | 1-13 | INV. G03F7/075 G03F7/20 |
| A | * paragraph [0319] * ----- | 14,15 | |
| X | EP 1 811 338 A (FUJIFILM CORP [JP]) 25 July 2007 (2007-07-25) * paragraphs [0040] - [0045], [0047] - [0053], [0061], [0062] * * paragraphs [0073] - [0079] * * paragraphs [0064] - [0066], [0069]; compound Z2 * * paragraphs [0091], [0056]; claim 4 * | 1-13 | |
| A | * paragraph [0091] * ----- | 14,15 | TECHNICAL FIELDS SEARCHED (IPC) |
| X | EP 1 795 963 A (FUJIFILM CORP [JP]) 13 June 2007 (2007-06-13) * paragraphs [0048] - [0058], [0065] - [0082], [0116], [0297] * * paragraphs [0205] - [0213], [0221], [0222] * * paragraphs [0126] - [0156], [0181], [0182]; compound Z2 * * paragraphs [0273] - [0276], [0283], [0287], [0102], [0086] * | 1-13 | G03F |
| A | * paragraph [0273] * ----- -/-- | 14,15 | |

The present search report has been drawn up for all claims

| Place of search | Date of completion of the search | Examiner |
|---|---|---|
| Munich | 10 December 2008 | Beckert, Audrey |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 08 16 2306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | EP 1 970 760 A (FUJIFILM CORP [JP]) 17 September 2008 (2008-09-17)<br>* paragraphs [0184] - [0190], [0199] - [0220], [0256] - [0260] *<br>* paragraphs [0102] - [0108], [0131] - [0151] *<br>* paragraphs [0274] - [0302], [0328] - [0330] *<br>* paragraphs [0388] - [0390], [0393], [0401], [0403], [0405], [0243], [0224] *<br>----- | 1-13 | |
| X | EP 1 720 072 A (ROHM & HAAS ELECT MATERIALS [US]) 8 November 2006 (2006-11-08)<br>* paragraphs [0011], [0013] *<br>* paragraphs [0016] - [0018], [0021], [0032] - [0034] *<br>* sentence 26, paragraph 26 - sentence 29 *<br>* paragraphs [0041], [0047] *<br>* paragraphs [0049], [0050] *<br>* paragraphs [0055], [0058], [0062], [0063] *<br>* example 3 *<br>----- | 1-3, 7-11,13 | TECHNICAL FIELDS SEARCHED (IPC) |
| A | WO 2004/040371 A (ARCH SPEC CHEM INC [US]) 13 May 2004 (2004-05-13)<br>* paragraphs [0014], [0046], [0054], [0057] *<br>* paragraphs [0079] - [0097] *<br>----- | 1-6 | |
| A | WO 02/082184 A (ARCH SPEC CHEM INC [US]) 17 October 2002 (2002-10-17)<br>* the whole document *<br>----- | 1 | |

The present search report has been drawn up for all claims

| Place of search | Date of completion of the search | Examiner |
|---|---|---|
| Munich | 10 December 2008 | Beckert, Audrey |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 08 16 2306

This annex lists the patent family members relating to the patent documents cited in the above-mentioned European search report.
The members are as contained in the European Patent Office EDP file on
The European Patent Office is in no way liable for these particulars which are merely given for the purpose of information.

10-12-2008

| Patent document cited in search report | Publication date | Patent family member(s) | Publication date |
|---|---|---|---|
| EP 1764652 A | 21-03-2007 | US 2007059639 A1 | 15-03-2007 |
| EP 1811338 A | 25-07-2007 | JP 2007219472 A | 30-08-2007 |
| | | US 2007172768 A1 | 26-07-2007 |
| EP 1795963 A | 13-06-2007 | JP 2007163606 A | 28-06-2007 |
| | | KR 20070061368 A | 13-06-2007 |
| | | US 2008171287 A1 | 17-07-2008 |
| | | US 2007148589 A1 | 28-06-2007 |
| EP 1970760 A | 17-09-2008 | KR 20080084745 A | 19-09-2008 |
| | | US 2008227025 A1 | 18-09-2008 |
| EP 1720072 A | 08-11-2006 | CN 1881085 A | 20-12-2006 |
| | | JP 2006309245 A | 09-11-2006 |
| | | KR 20060114293 A | 06-11-2006 |
| WO 2004040371 A | 13-05-2004 | EP 1558654 A2 | 03-08-2005 |
| | | JP 2006504827 T | 09-02-2006 |
| | | KR 20050074979 A | 19-07-2005 |
| WO 02082184 A | 17-10-2002 | EP 1299773 A1 | 09-04-2003 |
| | | JP 2004519734 T | 02-07-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006072326 A
- JP 2006309245 A


### Non-patent literature cited in the description


- **M. IRIE et al.** *Journal of Photopolymer Science and Technology,* 2006, vol. 19 (4), 565